# EUROPÄISCHE PATENTANMELDUNG

(11) **EP 2 169 687 A1**
(43) Veröffentlichungstag der Anmeldung: **31.03.2010**
(21) Anmeldenummer: 09168958.8
(22) Anmeldetag: 28.08.2009
(51) Int. Cl.: G21F 1/10, G21F 1/12

(54) **Vorrichtung zur Abschirmung eines Flächenbereiches mit einer Sperrschicht**

(30) Priorität: 25.09.2008 DE 202008012779 U
(71) Anmelder: Schillings, Hans, 41379 Brüggen (DE)
(72) Erfinder: Schillings, Hans, 41379 Brüggen (DE)
(74) Vertreter: Bonsmann, Joachim Bernhard

(57) **Zusammenfassung**

Es wird eine Vorrichtung zur Abschirmung eines Flächenbereiches mit einer Sperrschicht. insbesondere zur Abschirmung von Bauwerken gegen ein Eindringen von Radonstrahlung und/oder Feuchtigkeit beschrieben. Als Sperrschicht ist dabei ein als Schicht-Verbundwerkstoff aus unterschiedlichen Abschirmmaterialien ausgebildetes Flächengebilde vorgesehen. Hierbei ist vorteilhaft, dass durch die dadurch erzielte Kombination unterschiedlicher Abschirmmaterialen, die jeweils für sich genommen bereits gute Sperrwirkungseigenschaften haben, synergetische Effekte erzielt werden können, durch die die Abschirmwirkung gegenüber bekannten Sperrschichten entscheidend verbessert werden kann. Vorzugsweise weist der Schicht-Verbundwerkstoff Abschirmmaterialien (1, 3, 4) auf der Basis von Polyethylenterephthalat (PET) und/oder auf der Basis von Aluminium und/oder auf der Basis von Polyethylen auf.

## Beschreibung

Die Erfindung betrifft eine Vorrichtung zur Abschirmung eines Flächenbereiches mit einer Sperrschicht, insbesondere zur Abschirmung von Bauwerken gegen ein Eindringen von Radonstrahlung und/oder Feuchtigkeit.

Für die Abschirmung von Bauwerken gegen Feuchtigkeit ist der Einsatz von Kunststofffolien, Bitumenbahnen, Gussasphalt od. dgl. bekannt. Mittels derartiger Sperrschichten kann aber ein Eindringen natürlicher Isotope von Radon in Bauwerke nicht in zufriedenstellender Weise verhindert werden. Ein Eindringen von gesundheitsgefährlichen Gasen, Radon und Radonfolgeprodukten, zusammenfassend als Radonstrahlung bezeichnet, kann durch Konvektion und/oder Diffusion erfolgen. Folien als Sperrschicht, gut verdichteter Beton od. dgl. haben den Nachteil, dass die erstrebte Abschirmwirkung bei geringsten Lücken im Sperrsystem, bei mangelnder Sorgfalt bei dem Einbau, bei Altersrissen, Versetzungen und/oder mechanischen Beschädigungen der Sperrschicht verringert oder vollständig aufgehoben ist.

Es sind auch bereits Sperrsysteme vorgeschlagen worden, bei denen zwischen zwei einen Luftdurchtritt und einen Gasdurchtritt hemmenden Schichten ein sich weitgehend über die Fläche der Sperrschicht erstreckender Luftkanal vorgesehen ist, der mit einer oder mehreren druckregulierbaren Luftleitung(en) verbunden ist. Dieser Luftkanal weist einen zum Umgebungsdruck unterschiedlichen Luftdruck auf und dient dazu, unerwünschte Gase, Feuchtigkeit, Strahlung od. dgl. durch eine aus dem Kanal nach außen herausführende Luftströmung abzuleiten. Derartige Sperrsysteme sind aber sehr aufwendig und kostenintensiv.

Es ist weiterhin bekannt, in zur Abschirmung vorgesehene Sperrschichten, beispielsweise in Kunststofffolien oder Tapeten od. dgl., Aktivkohle enthaltende Substrate einzubetten, die die giftigen Gase durch Adsorption binden, bis diese zerfallen sind. Die Halbwertszeit beträgt dabei ca. 3,8 Tage. Nachteilig ist hierbei, dass die Zerfallsprodukte dann als feste Bestandteile dauerhaft auf der Aktivkohle fixiert sind, was eine Alpha-Strahlung zur Folge hat, die zumindest im extremen Nahbereich problematisch sein kann.

Der Erfindung liegt die Aufgabe zugrunde, eine Sperrschicht der eingangs genannten Art zu schaffen, die eine möglichst dichte Abschirmung insbesondere gegen Radonstrahlung bildet, die aber gleichzeitig auch zur Abschirmung gegen Feuchtigkeit bei Bauwerken eingesetzt werden kann.

Diese Aufgabe wird erfindungsgemäß dadurch gelöst, dass als Sperrschicht ein als Schicht-Verbundwerkstoff aus unterschiedlichen Abschirmmaterialien ausgebildetes Flächengebilde vorgesehen ist. Hierbei ist vorteilhaft, dass durch die Kombination unterschiedlicher flächiger Materialien, die jeweils für sich genommen bereits gute Sperrwirkungseigenschaften haben, synergetische Effekte erzielt werden können, durch die die Abschirmwirkung der erfindungsgemäßen Sperrschicht gegenüber bekannten Sperrschichten entscheidend verbessert werden kann.

In bevorzugter Ausgestaltung der Erfindung ist vorgesehen, dass das Flächengebilde Abschirmmaterialien auf der Basis von Polyethylenterephthalat (PET) und/oder auf der Basis von Aluminium und/oder auf der Basis von Polyamiden (PA) und/oder auf der Basis von Polyethylen aufweist.

In zweckmäßiger Ausbildung der Erfindung kann weiterhin vorgesehen sein, dass das Flächengebilde als nach Art der Aufbringung einer Bitumenbahn auf die Oberfläche eines Flächenbereichs aufbringbare Dichtungsbahn ausgebildet ist.

In weiterer Ausbildung der Erfindung kann vorgesehen sein, dass das Flächengebilde mit einem Glasvlies extrusionskaschiert ist. Wenn das Glasvlies durch ein Extrusionsbeschichtungsverfahren auf das Flächengebilde aufgebracht ist, ist hierdurch ein idealer Träger beispielsweise zum Auftragen einer Bitumenbahn entstanden. Auf diese Weise kann ein Flächenverbund geschaffen werden, der zum einen nach den im Bauwesen üblicherweise gebräuchlichen Technologien verarbeitet werden kann und zum anderen die gewünschte Abschirmung bewirkt.

In zweckmäßiger Ausgestaltung der Erfindung kann eine Schicht auf der Basis von Polyethylenterephthalat mit einer weiteren Schicht auf der Basis von Aluminium mittels eines Pur-Klebstoffs flächig verbunden sein. Bei der Schicht auf der Basis von Polyethylenterephthalat handelt es sich vorzugsweise um eine Folie mit einer Dicke in der Größenordnung von 12 µm. Vorzugsweise ist die Schicht auf der Basis von Aluminium eine Folie in der Größenordnung von 7 µm.

Das Glasvlies weist vorzugsweise ein Gewicht von ca. 40g/m² auf.

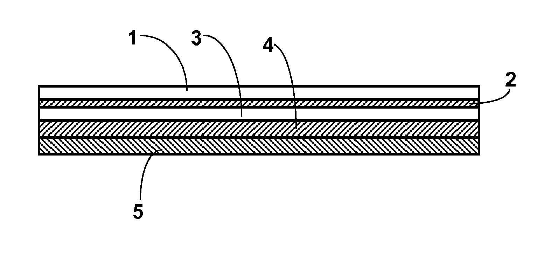

Die Erfindung wird nachfolgend anhand des in der Zeichnung dargestellten Ausführungsbeispiels näher erläutert. Die Figur zeigt eine Querschnittsdarstellung eines Ausführungsbeispiels einer Sperrschicht gemäß der Erfindung.

Ein Schicht-Verbundwerkstoff weist unterschiedliche Abschirmmaterialien auf, und zwar eine Folie 1 auf der Basis von Polyethylenterephthalat (PET), die auf ihrer Unterseite flächig mittels eines Pur-Klebstoffs 2 flächig mit einer als Aluminiumfolie ausgebildeten weiteren Schicht 3 auf der Basis von Aluminium verbunden ist. Die Aluminiumfolie 3 ist an ihrer Unterseite mit einer als Folie ausgebildeten Schicht 4 auf der Basis von Polyamid verbunden. Anstelle von Polyamid kann die Folie auch aus Polyethylen bestehen. Die gesamte beschriebene Anordnung ist an der Unterseite der Schicht 4 mit einem Glasvlies 5 extrusionskaschiert. Bei dem Schichtaufbau ist darauf zu achten, dass empfindliche Materialien, wie beispielsweise Aluminiumfolien, schützend umhüllt sind. Dies wird bei dem dargestellten Ausführungsbeispiel der Erfindung dadurch erreicht, dass die Aluminiumfolie im Inneren des Schicht-Verbundwerkstoffes angeordnet ist.

## Patentansprüche

1. Vorrichtung zur Abschirmung eines Flächenbereiches mit einer Sperrschicht, insbesondere zur Abschirmung von Bauwerken gegen ein Eindringen von Radonstrahlung und/oder Feuchtigkeit,
**dadurch gekennzeichnet, dass**
als Sperrschicht ein als Schicht-Verbundwerkstoff aus unterschiedlichen Abschirmmaterialien (1, 3, 4) ausgebildetes Flächengebilde vorgesehen ist.

2. Vorrichtung nach Anspruch 1,
**dadurch gekennzeichnet, dass**
das Flächengebilde Abschirmmaterialien auf der Basis von Polyethylenterephthalat (PET) (1) und/oder auf der Basis von Aluminium (3) und/oder auf der Basis von Polyamiden (PA) (4) und/oder auf der Basis von Polyethylen aufweist.

3. Vorrichtung nach Anspruch 1 oder 2,
**dadurch gekennzeichnet, dass**
das Flächengebilde als nach Art der Aufbringung einer Bitumenbahn auf die Oberfläche eines Flächenbereichs aufbringbare Dichtungsbahn ausgebildet ist.

4. Vorrichtung nach einem der Ansprüche 1 oder 3,
**dadurch gekennzeichnet, dass**
das Flächengebilde mit einem Glasvlies (5) extrusionskaschiert ist.

5. Vorrichtung nach einem der Ansprüche 1 bis 4,
**dadurch gekennzeichnet, dass**
die Schicht (1) auf der Basis von Polyethylenterephthalat mit einer weiteren Schicht (3) auf der Basis von Aluminium mittels eines Pur-Klebstoffs (2) flächig verbunden ist.

6. Vorrichtung nach einem der Ansprüche 1 bis 5,
**dadurch gekennzeichnet, dass**
die Schicht (1) auf der Basis von Polyethylenterephthalat eine Folie ist, deren Dicke in der Größenordnung von 12 µm liegt.

7. Vorrichtung nach einem der Ansprüche 1 bis 6,
**dadurch gekennzeichnet, dass**
die Schicht (3) auf der Basis von Aluminium eine Folie ist, deren Dicke in der Größenordnung von 7 µm liegt.

8. Vorrichtung nach einem der Ansprüche 4 bis 7,
**dadurch gekennzeichnet, dass**
das Glasvlies (5) ein Gewicht von ca. 40g/m² aufweist.
